# EUROPEAN PATENT SPECIFICATION

(11) **EP 3 853 907 B1**
(45) Date of publication and mention of the grant of the patent: **02.12.2026**
(21) Application number: 19780173.1
(22) Date of filing: 20.09.2019
(51) Int. Cl.: H10D 8/60, H10D 8/01, H10D 62/10, H10D 64/23, H10D 84/80

(54) **INTEGRATED SEMICONDUCTOR VERTICAL SCHOTTKY DIODE AND METHOD OF MANUFACTURING THEREOF**
INTEGRIERTE VERTIKALE HALBLEITERSCHOTTKY-DIODE UND VERFAHREN ZU IHRER HERSTELLUNG
DIODE SCHOTTKY VERTICALE INTEGRÉE À SEMI-CONDUCTEUR ET SON PROCÉDÉ DE FABRICATION

(30) Priority: 21.09.2018 IT 201800008823
(43) Date of publication of application: 28.07.2021
(73) Proprietor: LFoundry S.r.l., 67051 Avezzano (IT)
(72) Inventor: SCHMIDT, Carsten, 67051 Avezzano (IT); SPITZLSPERGER, Gerhard, 67051 Avezzano (IT)
(74) Representative: De Tullio, Michele Elio
(86) International application number: PCT/EP2019/075320
(87) International publication number: WO 2020/058473

(56) References cited:
- EP-A1- 2 913 847
- CN-B- 102 694 033
- JP-A- 2007 317 839
- TW-A- 201 601 327
- US-A1- 2006 071 271
- US-A1- 2008 296 722
- US-B1- 6 825 073

## Description

The present solution relates to a semiconductor vertical Schottky diode, and to a corresponding manufacturing process; in particular, the following disclosure will make reference to a semiconductor vertical Schottky diode fabricated in Complementary Metal-Oxide-Semiconductor (CMOS) technology.

As it is known, a Schottky diode is mainly used as a switching element or as a rectification element and uses a metal-semiconductor junction having superior high-speed switching characteristics as compared with a general PN junction diode. This is because minority carrier injection does not occur when a forward voltage is applied to the Schottky diode, differently from a p-n junction diode; in a Schottky diode, a current flows by majority carriers only.

Semiconductor Schottky diodes are extensively found in the art.

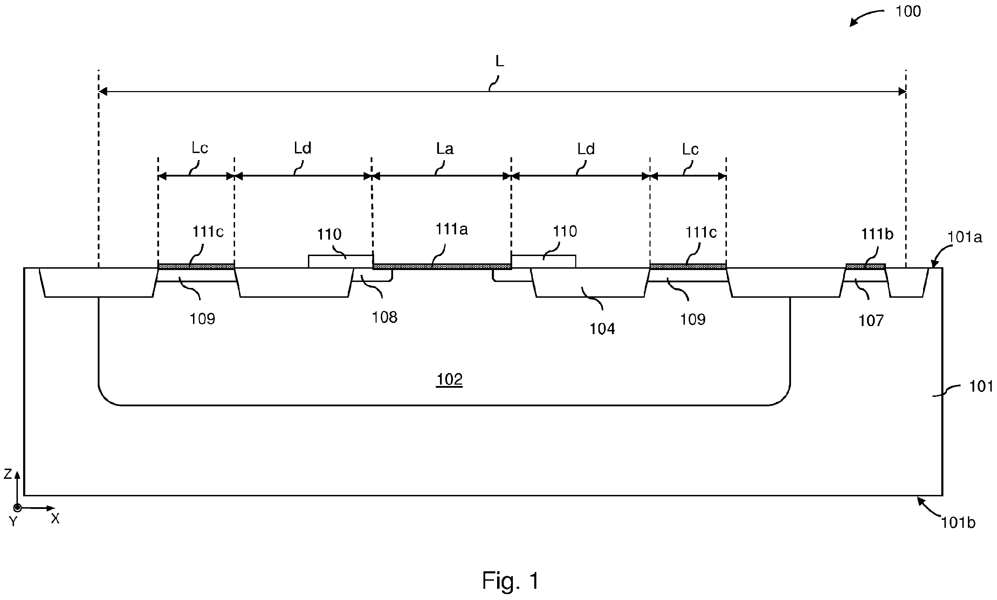

For example, Figure 1 shows a typical integrated high voltage Schottky diode with a lateral drift region, denoted in general with 100 (a diode of this type is disclosed e.g. in US 2012/068297 A1). The Schottky diode 100 is formed in a substrate 101 of semiconductor material, in particular silicon; substrate 101 has a frontside surface 101a and a back surface 101b, with a main extension in a horizontal plane xy and separated along a vertical direction z, orthogonal to the same horizontal plane xy. A lightly doped well 102 of a first conductivity type, for example n-type, is formed in a surface portion of the substrate 101, abutting (or facing) the frontside surface 101a; the substrate 101 has a doping of a second conductivity type, in the example a p-type doping. Shallow trench isolation regions 104, of a dielectric material, formed in the substrate 101, at the frontside surface 101a thereof, provide a spatial separation between anode, cathode and body electrodes of the Schottky diode 100.

In particular, a first electrode, e.g. an anode electrode, 111a of the Schottky diode 100 (in the case of semiconductor n-type conductivity), constituted by a metal silicide contact formed on the lightly doped well 102, establishes a Schottky contact with the same lightly doped well 102. The silicide formation is blocked laterally by means of a silicide blocking layer 110, formed on the frontside surface 101a of the substrate 101; an opening 112 is defined in the silicide blocking layer 110, through which the metal silicide and the corresponding Schottky contact area are defined.

The edge of the Schottky contact area is usually prone to increased leakage; therefore, a guard ring 108, being a doped region of the second conductivity type (in the example, p-type), is formed in the lightly doped well 102, at the perimeter region of the Schottky contact area. A second electrode, e.g. a cathode electrode, 111c of the Schottky diode 100 is established by forming an Ohmic metal contact on the lightly doped well 102 (which, in this case, has n-type conductivity). This is accomplished by forming a metal silicide contact on a highly doped region 109 formed in the lightly doped well 102, at the frontside surface 101a of the substrate 101. The highly doped region 109 has the first conductivity type (n-type) and is formed e.g. by ion implantation. In Figure 1, two cathode electrodes 111c are shown, laterally delimited by respective shallow trench isolation regions 104.

It is to be noted, in any case, that in a Schottky diode, being a metal/semiconductor junction diode, the metal side is called the anode and the semiconductor side is called the cathode, when the semiconductor is n-type. If, in the contrary, the semiconductor is p-type (i.e. the lightly doped well 102 has p-type conductivity), the metal side forms the cathode and the semiconductor side forms the anode of the Schottky diode.

Moreover, a substrate (or body) electrode 111b is provided by forming a further metal silicide contact on a further highly doped region 107, having the second conductivity type (p-type) and formed in the substrate 101, at the frontside surface 101a, outside of the lightly doped well 102. The highly doped regions 107, 109 are separated by a shallow trench isolation region 104.

In many applications, it is required that the Schottky diode 100 is able to sustain high voltages in reverse bias, with a breakdown voltage for example of about 30 V. In order to achieve such a high breakdown voltage, anode and cathode electrodes 111a, 111c need to be spatially separated in the lightly doped well 102; the length of separation is denoted by Ld in Figure 1, where La denotes the length of the anode electrode 111a, Lc denotes the length of the cathode electrode 111c, and L denotes the total length in the lateral direction (along the x axis of the horizontal plane xy, in Figure 1) of the Schottky diode 100, including also the substrate electrode 111b.

An important characteristic for an integrated Schottky diode is the area consumption needed to provide a specific forward current. For a given Schottky diode design, the forward current depends on the size of the Schottky contact. The area efficiency of the Schottky diode can be defined as the ratio of the Schottky contact area to the total area of the Schottky diode. As is obvious from Figure 1, the area efficiency of the Schottky diode 100 is not optimal; this being due to the lateral configuration of the diode and to the fact that optimum settings exist for lengths La and Lc given by the design. Increasing the length La beyond its optimum value will result in an unnecessary high series resistance of the Schottky diode. To provide a large forward current, the Schottky diode thus needs to have a large width (along the y axis of the horizontal plane xy) accordingly, or a multi-stripe structure has to be used, in any case entailing a high area occupation.

The Schottky diode 100 has further disadvantages. The guard ring 108, the lightly doped well 102 and the substrate 101 form a parasitic bipolar transistor. Depending on the current gain of this parasitic bipolar transistor, the Schottky characteristics of the Schottky diode 100 may significantly deviate from desired characteristics. The guard ring 108 introduces also a parasitic capacitance and gives rise to minority carrier injection deteriorating the switching performance. Since there is an optimum value for the length La of the Schottky contact, the parasitic capacitance of the Schottky diode 100 cannot be easily reduced. Moreover, the Schottky diode 100 shown in Figure 1 is not isolated, so that currents may flow towards the substrate 101.

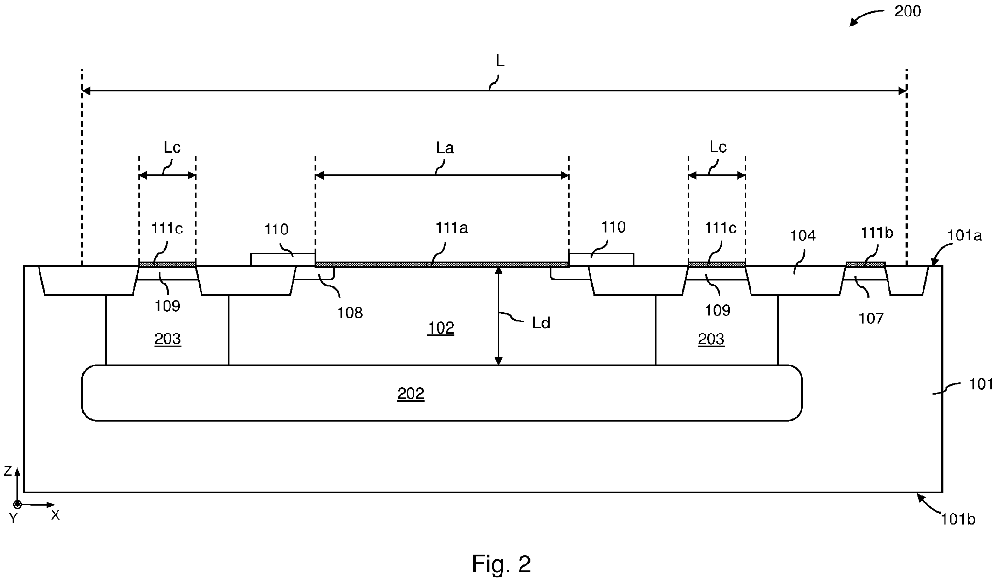

Figure 2 show another typical Schottky diode configuration, denoted with 200, in this case having a vertical drift region (a diode of this type is disclosed e.g. in US 2008/296722 A1).

The Schottky diode 200 is generally similar to the Schottky diode 100 of Figure 1 (so that corresponding elements are denoted with the same references and are not discussed again), but includes a highly doped buried layer 202, having the first conductivity type (n-type), formed directly below and in contact with the lightly doped well 102.

The highly doped region 109 of the cathode electrode 111c of the Schottky diode 200 is in this case connected to the buried layer 202 via a highly doped connecting region 203, having the first conductivity type (n-type), extending along the vertical direction z. The highly doped connecting region 203 may be formed by a sequence of high dose implants of varied implant energy. The highly doped connecting region 203 is commonly called a "sinker". The lightly doped well 102 is in this case laterally delimited by two highly doped connecting regions 203, corresponding to the two cathode electrodes 111c.

In the Schottky diode 200, the length La of the Schottky contact area can be made quite large due to the vertical configuration.

In the forward bias, the current flows vertically through the lightly doped well 102 reaching the highly doped buried region 202. The highly doped buried region 202 collects the current, which then flows laterally through the same highly doped buried layer 202 to reach the highly doped connecting regions 203, from the which the cathode contacts 111c are reached. In reverse bias, the applied voltage drops vertically across the depleted region of the lightly doped well 102.

The vertical-drift configuration of the Schottky diode 200 allows a higher area efficiency compared to that of the Schottky diode 100 of Figure 1. However, the buried layer 202 and the highly doped connecting regions 203 increase the series resistance of the Schottky diode 200. The larger the Schottky contact length La, the larger the series resistance associated with the highly doped buried layer 202. As a consequence, there is again an optimum value for the length La, limiting the area efficiency of the Schottky diode 200.

A further known solutions for a semiconductor Schottky diode is disclosed e.g. in US 7,002,187 B1, which discloses a Schottky diode formed on an epitaxial (epi) layer. An N+ buried channel is formed in a substrate on which the epi layer is grown. The N+ buried channel is accessed by an oxidized vertical metal slot, which is connected to a metal electrode, arranged on the epi layer, that forms the cathode of the Schottky diode. A further metal electrode, also arranged on the epi layer, forms the anode of the Schottky diode. P+ guard rings are formed laterally in the epi layer, to solve the problem of high edge leakage due to high junction curvature.

Also in this known solution, the N+ buried layer introduces a parasitic series resistance, whose value increases with increasing lateral dimensions of the Schottky contact area.

JP 2007 317839 A and US 2006/071271 A1 disclose a respective semiconductor device having a discrete Schottky diode, with TSV (Through Silicon Via) structures formed in a respective substrate, so that an electrode provided on a lower surface of the substrate can be routed to an upper surface of the same substrate.

The aim of the present invention is to provide an improved solution for a semiconductor Schottky diode, allowing to overcome the limitations of known solutions, for example in terms of area efficiency, manufacturing costs and electrical performances.

According to the present solution, a semiconductor integrated vertical Schottky diode device and a corresponding manufacturing process are consequently provided, as defined in the appended claims.

For a better understanding of the present invention, preferred embodiments thereof are now described purely by way of non-limiting example and with reference to the attached drawings, wherein:
- Figure 1 is a cross-section of a known semiconductor Schottky diode;
- Figure 2 is a cross-section of another known semiconductor Schottky diode;
- Figure 3 is a cross-section of a semiconductor vertical Schottky diode, according to a first embodiment of the present solution;
- Figures 4-7 are cross-sections of further embodiments of a semiconductor vertical Schottky diode according to the present solution; and
- Figures 8A-8K are cross sections of the semiconductor vertical Schottky diode of Figure 3 in subsequent steps of a corresponding manufacturing process.

As will be discussed in details in the following, an aspect of the present solution envisages forming the Ohmic metal (cathode) contact of the Schottky diode on the thinned backside of a substrate, opposite to the Schottky (anode) contact established on the frontside of the same substrate. Schottky contact and Ohmic contact have approximately the same size in the horizontal plane and are separated in the vertical direction by the lightly doped substrate in-between. The Schottky contact on the frontside is formed by standard CMOS processes. The electrical contact on the thinned backside is made available to the wirings (conductive interconnections) on the front side by a Through Silicon Via (TSV) structure, which laterally encloses the Schottky diode, thus also providing full dielectric isolation thereof.

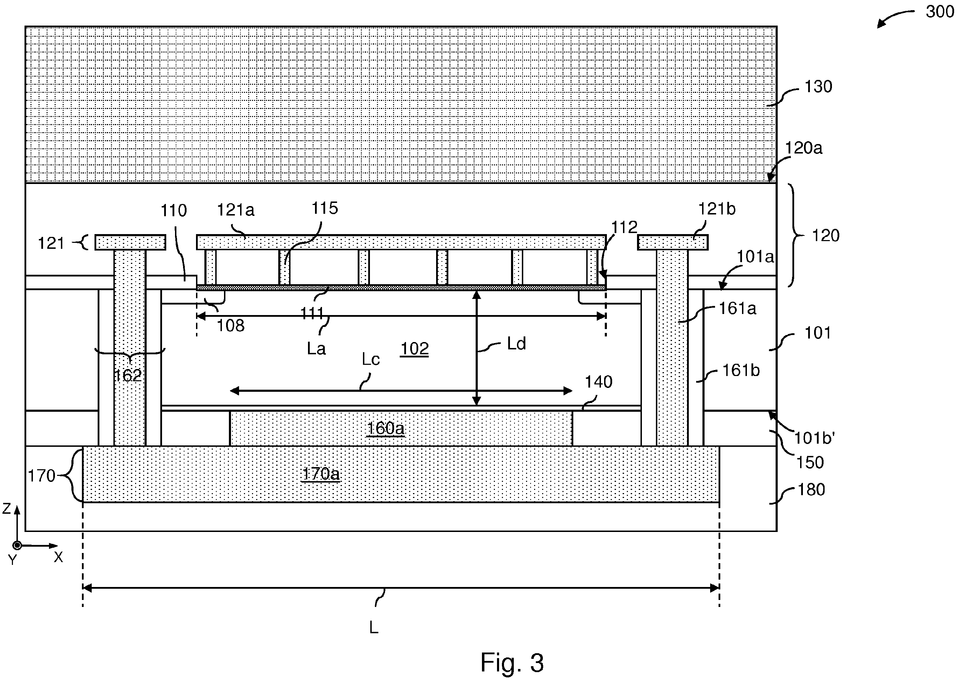

Figure 3 shows an integrated high-voltage vertical Schottky diode 300 according to a first embodiment of the present solution, manufactured with standard CMOS technology.

The Schottky diode 300 is formed on a semiconductor substrate, again denoted with 101 (in Figure 3 and in the following Figures, corresponding elements are again denoted with the same references), having a frontside surface 101a. The substrate 101 is preferably a silicon wafer, or an epitaxial silicon layer. A lightly doped region (so called well) 102 is formed in a surface portion of the substrate 101, facing the frontside surface 101a and having a first conductivity type (for example n-type); the substrate 101 has a second conductivity type, in the example p-type (n-type doping is, however, also possible, as well as the use of other semiconductor materials).

A metal region 111 is formed on the lightly doped well 102, on the frontside surface 101a of the substrate 101, to define a Schottky contact with the lightly doped well 102.

In the preferred embodiment, the metal region 111 is a metal silicide layer, preferably a cobalt silicide layer; as it is known, in many CMOS processes cobalt silicide is used to reduce source and drain contact resistances, so that this material is easily available for the formation of the Schottky diode 300 (use of other metals or metal silicides is in any case as well possible).

In many CMOS processes, the silicidation of silicon or polysilicon can be blocked where it is unwanted. This is accomplished by deposition of silicide blocking layer 110 on the frontside surface 101a, through which an opening 112 is formed by a photo-masking etching step, to define the surface area of the lightly doped well 102 where silicidation takes place. The silicide blocking layer 110 is usually a silicon oxide layer or a stacked-layer consisting of a silicon oxide and a silicon nitride layer.

At the edge of the metal region 111 a guard ring 108 is formed in the surface portion of the substrate 101. The guard ring 108 is a doped region having the opposite conductivity type of the lightly doped well 102, in the example the second conductivity type (p-type). The guard ring 108 may be formed by implantation and subsequent annealing steps. In the embodiment of Figure 3, the guard ring 108 has an overlap with respect to the metal region 111.

It is known that at the edge of a cobalt silicided region often a high number of surface states and traps exists, which can give rise to an increased leakage level; moreover, due to the curvature of the cobalt silicide in the perimeter region, high electric fields may occur at this position, when a reverse bias is applied. The guard ring 108 effectively reduces the leakage of the Schottky diode 300 originating from the edge of the cobalt silicided area. Since the guard ring 108 has the doping of the second conductivity type, a p-n junction is formed with the lightly doped well 102.

As in standard CMOS processes, a CMOS layer stack is arranged on the frontside surface 101a of the substrate 101, including a number of dielectric and interconnected conductive layers. For sake of simplicity, Figure 3 shows an intermetal dielectric layer 120 and a single interconnection metal layer 121 (the first interconnection metal layer), arranged in the intermetal dielectric layer 120 (however, further metal layers, separated by the dielectric layer, are generally envisaged, as will be clear for a skilled person). The first interconnection metal layer 121 is made of a conductive material like tungsten, aluminum, copper or the like; the intermetal dielectric layer 120 is made of silicon oxide or other dielectric materials, preferably having low dielectric constant.

Electrical contacts 115, formed in the intermetal dielectric layer 120 and extending in the vertical direction z, establish a connection between the metal region 111 and a first interconnection pad 121a formed in the first interconnection metal layer 121. As shown in Figure 3, contacts 115 may also be formed where the guard ring 8 overlaps the cobalt silicide area.

In particular, the metal region 111 constitutes the first electrode, in the example the anode electrode, of the Schottky diode 300, and the contacts 115 and the first interconnection pad 121a allow to access this anode electrode from the frontside of the Schottky diode 300, e.g. by an integrated circuit formed in the same substrate 101 (here not shown), via suitable electrical connection paths.

As previously discussed, in Figure 3 only one interconnection layer (the first interconnection metal layer 121) is shown, however, several interconnection metal layers and corresponding vias are possible and common.

According to an aspect of the present solution, contrary to standard CMOS solutions, no bonding or bumping pads are formed at the last interconnection metal level; instead, the top surface 120a of the intermetal dielectric layer 120 is bonded to a carrier wafer 130. The carrier wafer 130 may be a further silicon wafer or a wafer made of a different type of material that is compatible with standard CMOS processing. In particular, a permanent bond is formed between the intermetal dielectric layer 120 and the carrier wafer 130 (in any known manner, here not discussed in detail).

With the help of the carrier wafer 130, as will be also discussed in more details in the following, the substrate 101 is thinned from the backside (i.e. starting from a back side, opposite to the frontside surface 101a), such that the well 102 is exposed at a thinned backside surface, denoted with 101b' (in other words, the thickness of the well 102 corresponds to that of the thinned substrate 101).

A shallow and highly doped region 140 is formed at this backside surface 101b', within the area of the lightly doped well 102. The highly doped region 140 has the first type of conductivity, in the example n-type.

A dielectric layer 150, e.g. of silicon oxide, is arranged on the backside surface 101b', having a backside contact opening within the area of the highly doped region 140. The backside contact opening is filled with a conductive region, e.g. of tungsten, aluminum or copper, which forms the second electrode, in the example the cathode electrode 160a, of the Schottky diode 300, defining an Ohmic contact with the highly doped region 140.

To make the cathode electrode 160a of the Schottky diode 300 available to the frontside 101a of the substrate 101 and to the electrical interconnections formed thereon (e.g. towards the integrated circuit formed in the same substrate 101), a through silicon via (TSV) structure 162 is formed.

The through silicon via structure 162 extends from a bottom surface of the dielectric layer 150, through the whole thickness of the substrate 101, to a second interconnection pad 121b, formed in the same first interconnection metal layer 121 as the first interconnection pad 121a.

The through silicon via structure 162 includes a conductive filling 161a, of a conductive material like tungsten, aluminum or copper (which may be the same material of the cathode electrode 160a, or a different material), and by a dielectric liner 161b, e.g. of silicon oxide, surrounding the conductive filling 161a and electrically isolating the conductive via from the substrate 101. An electrical contact between the conductive filling 161a of the through silicon via structure 162 and the second interconnection pad 121b is thus established.

Moreover, a first interconnection region 170a, formed in a first interconnection layer 170, arranged above the backside surface 101b' (in particular, on the dielectric layer 150) establishes an electrical connection between the cathode electrode 160a and the conductive filling 161a of the through silicon via structure 162. In this way, the cathode electrode 160a of the Schottky diode 300, formed on the backside surface 101b', is made available to the wirings formed on the frontside surface 101a of the substrate 101.

In Figure 3 only one interconnection layer on the backside is shown, where the first interconnection region 170a is formed. In general, however, more interconnection layers with corresponding vias are possible, or even required, formed in a respective intermetal dielectric layer 180, which could be made of silicon oxide or of a different dielectric material.

In the embodiment shown in Figure 3, the Schottky diode 300 is laterally enclosed by the through silicon via structure 162 (the lightly doped well 102 laterally extends to, and is surrounded by, the same through silicon via structure 162), such that the entire substrate region enclosed by the through silicon via structure 162 is electrically insulated from the external region of the same substrate 101. The guard ring 108 extends laterally from the metal region 111, up to the through silicon via structure 162. Also, the highly doped region 140 extends laterally up to the through silicon via structure 142, such that the highly doped region 140 is arranged on the entire backside surface 101b' inside of the enclosure defined by the through silicon via 162.

In the embodiment shown in Figure 3, therefore, the through silicon via structure 162 does not only operate to bring the cathode contact of the Schottky diode 300 to the frontside surface 101a of the substrate 101, but also to provide a dielectric isolation for the Schottky diode (e.g. from the further integrated circuit formed in the same substrate 101).

Since the through silicon via structure 162 encloses the Schottky diode 300, also the second interconnection pad 121b encloses the first interconnection pad 121a; at least a second interconnection level (not shown in Figure 3) may therefore be present to make the anode and cathode of the Schottky diode 300 available to the integrated circuit.

During operation, if a positive voltage is applied to the anode electrode 111 with respect to the cathode electrode 160a, a current flows between the same anode and cathode electrodes 111, 160a through the lightly doped well 102. The current flow is essentially vertical. The amount of forward current depends also on the series resistance of the Schottky diode 300. The series resistance of the Schottky diode 300 is given by the series resistance of the lightly doped well 102, the series resistance of the Ohmic contact on the backside and the series resistances of all metal interconnections involved. If a negative voltage is applied to the anode electrode 111 with respect to the cathode electrode 160a, only a leakage current flows, provided that the applied voltage is lower than the breakdown voltage of the Schottky diode 300. In such reverse bias condition, the lightly doped well 102 becomes partially or fully depleted and the applied electrostatic potential drops across the depleted region. Since anode and cathode electrodes 111, 160a are placed on opposite sides of the thinned substrate 101, the electrostatic equipotential distribution is nearly planar and parallel to the silicon surface. The breakdown voltage of the Schottky diode 300 depends on the doping concentration and thickness of the lightly doped well 102, which is equal to the thickness of the substrate 101 after its thinning.

It is noted that, in Figure 3, La denotes the length of the anode electrode 111, Lc the length of the cathode electrode 160a and Ld the length of the vertical drift region.

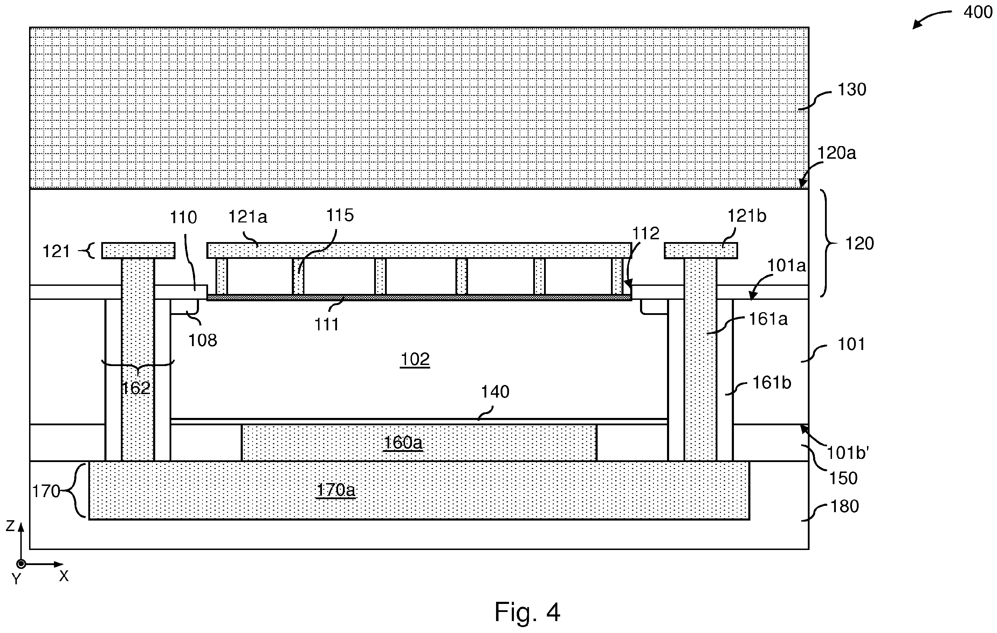

Figure 4 shows an alternative embodiment of the present solution.

The Schottky diode, here denoted with 400, differs from the Schottky diode 300 of Figure 3 only in that the guard ring 108 has no overlap with the metal region 111 (i.e. with the anode electrode). The guard ring 108 is arranged below the silicide blocking layer 110, being floating, without having an electrical connection to the anode of the Schottky diode 300. In this embodiment, the guard ring 108 still helps to reduce the electrical field at the edge of the cobalt silicided area in the reverse bias condition, provided that the spacing between the guard ring 108 and the metal region 111 is not too large. The floating guard ring 108 of the Schottky diode 400, however, does not provide a means to reduce a leakage current caused by a higher number of surface states or traps at the edge of the cobalt silicide layer. The advantage of the floating guard ring 108 is that no parallel p-n junction diode is formed in the perimeter region of the Schottky diode 400, as instead is the case for the embodiment of Figure 3. The Schottky diode characteristics are thus not impaired by the existence of a parasitic p-n junction diode. The Schottky diode 400 has a lower minority carrier injection and a lower parasitic capacitance compared to the Schottky diode 300.

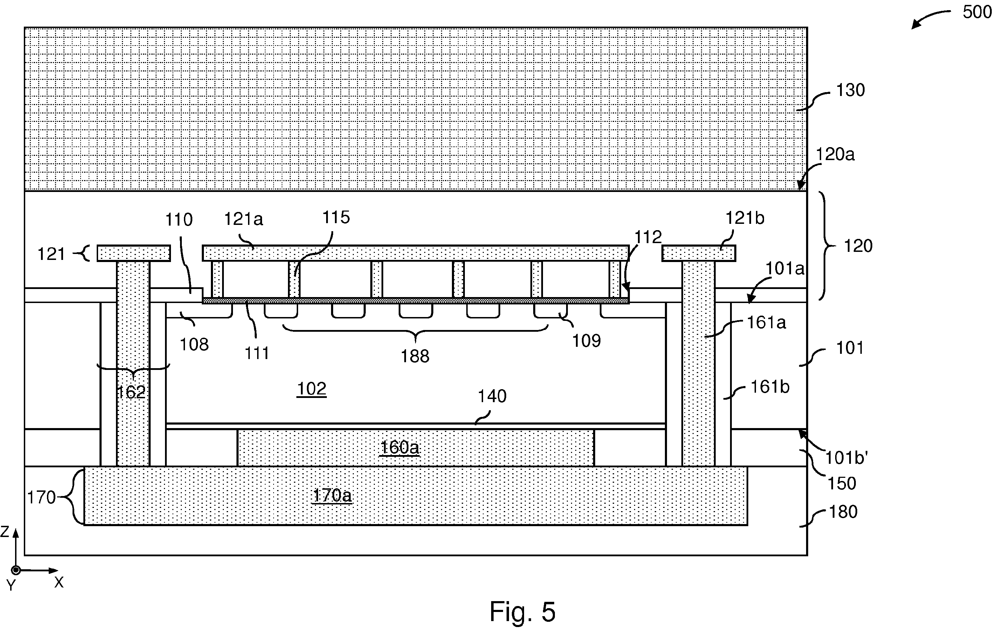

Figure 5 shows yet another embodiment of the present solution. The Schottky diode, here denoted with 500, differs from the embodiment shown in Figure 3 only in that a grid 188 of doped regions 109 of the second conductivity type (p-type) are formed in the lightly doped well 102 at the frontside surface 101a of the substrate 101. The grid 188 of doped regions 109 may be formed together with the guard ring 108 (e.g. with a same implantation step). The doped regions 109 have identical width and are equidistant in the horizontal plane xy. Different grid layout could be considered: for instance, the doped regions 109 could form concentric rings around the center of the cobalt silicide area, in the case where the same cobalt silicide area has a circular shape.

If a negative voltage is applied to the anode electrode 111 with respect to the cathode electrode 160a, the doped regions 109 of the grid 188 assist in the depletion of the lightly doped well 102. As a consequence, the reverse leakage current is reduced.

The grid 188 of doped regions 109 constitutes a p-n junction diode in parallel to the Schottky diode 500. If a positive voltage is applied to the anode with respect to the cathode, which is larger than the turn-on voltage of the Schottky diode 500, but lower than the built-in voltage of this p-n junction diode, the forward current is to a large extent determined by the characteristics of the Schottky diode 500. However, the forward current is lower compared to the forward current of the Schottky diode 300 of Figure 3, if the Schottky diode 500 is of the same size as the Schottky diode 300. If the applied positive voltage is larger than the built-in voltage of the above p-n junction diode, the paralleled p-n junction diode contributes to the forward current. The forward characteristics then deviates from the forward characteristics of a pure Schottky diode. For low biasing conditions, the Schottky diode 500 has an improved Ion/Ioff ratio, but the area consumption is increased and the switching performance may be reduced.

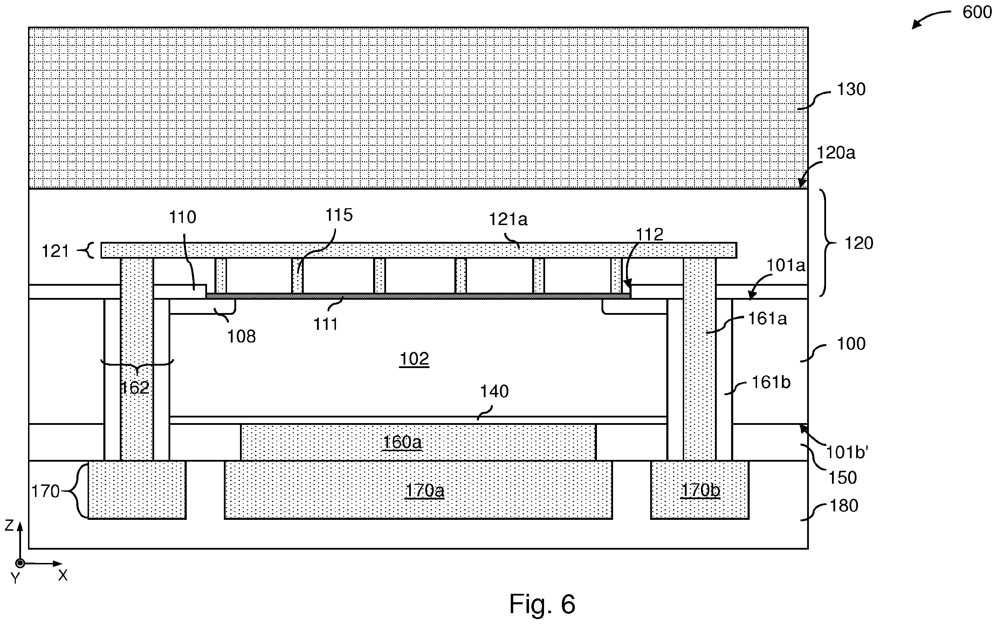

Figure 6 shows still another alternative embodiment of the present solution.

The Schottky diode, here denoted with 600, differs from the Schottky diode 300 shown in Figure 3 in that the anode and the cathode electrodes 111, 160a of the Schottky diode 600 are made available to the wirings (electrical connections) formed on the thinned backside surface 101b' of the substrate 101.

The through silicon via structure 162 is therefore used in this embodiment to bring the anode electrode 111 to the backside of the substrate 101. The first interconnection pad 121a achieves here an electrical connection between the contacts 115 formed on the cobalt silicide layer of the anode electrode 111 and the conductive filling 161a of the through silicon via structure 162. The first interconnection region 170a is again arranged above the backside surface 101b', in contact with the cathode electrode 160a; moreover, a second interconnection region 170b is formed in the same backside interconnection layer 170, in contact with the conductive filling 161a of the through silicon via structure 162.

It is noted that, to make the anode and the cathode of the Schottky diode 600 available to the wirings on the backside of the substrate 101, at least a second interconnection metal layer may be present on the backside (in a manner not shown, but that will be evident for a skilled person) .

As the CMOS manufacturing process allows to form wirings on the frontside surface 101a of the substrate 101 as well as on the backside surface 101b' of the same substrate 101, it might indeed be useful in some instances to have both the anode and the cathode electrodes 111, 160a available to the wirings formed on the same backside surface 101b'. It might also be considered to have the anode electrode 111 of the Schottky diode available to the wirings on the frontside of the substrate 101 and the cathode electrode 160a available to the wirings formed on the backside of the same substrate 101. In this configuration (here not shown, **which is not covered by the claims**) the through silicon via structure 162 may have the only function to provide a lateral dielectric isolation for the Schottky diode; the same through silicon via structure 162 could in that case be electrically set at a reference voltage (ground) or left floating.

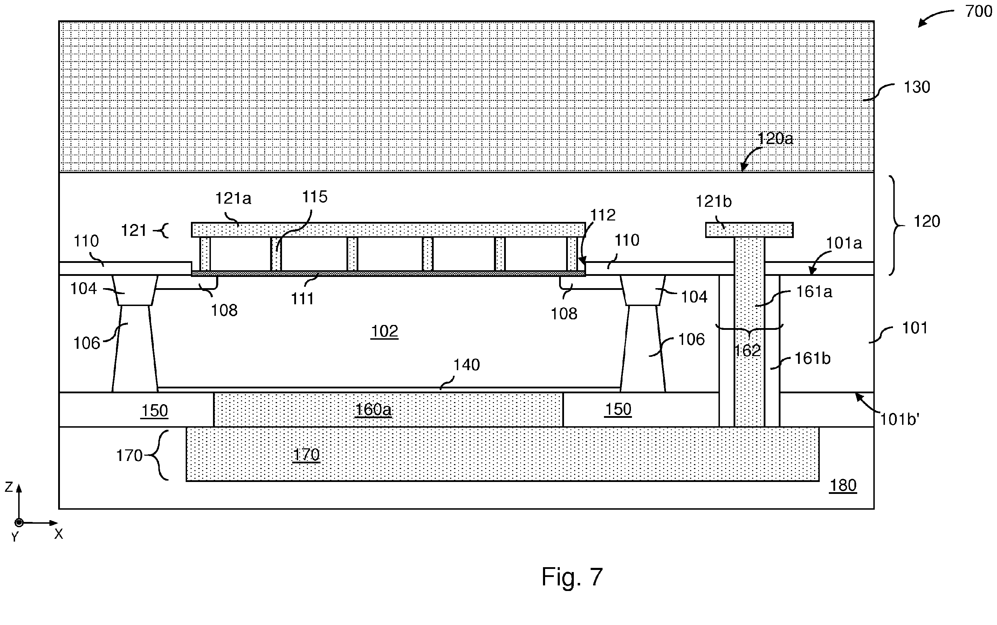

Figure 7 shows a further alternative embodiment of the present solution.

The Schottky diode, here denoted with 700, differs from the Schottky diode 300 shown in Figure 3 by being enclosed by a deep trench isolation 106.

The deep trench isolation 106 is formed by etching a trench extending from the backside surface 101b' towards the frontside surface 101a of substrate 101 and by filling the trench with a dielectric material, e.g. silicon oxide. The deep trench isolation 106 may extend (as shown in the same Figure 7) from the backside surface 101b' of the substrate 101 to a shallow trench isolation 104 formed at the frontside surface 101a of the substrate 101. Shallow trench isolations are common in standard CMOS processes.

The lightly doped well 102 extends to the deep trench isolation 106 such that the entire substrate region enclosed by the deep trench isolation 106 has the doping of the lightly doped well. The guard ring 108 extends laterally from the anode electrode 111 to the shallow trench isolation 104. Moreover, the highly doped region 140 extends laterally to the deep trench isolation 106, such that the highly doped region 140 is arranged over the entire backside surface 101b' inside of the deep trench isolation enclosure.

In this case, the Schottky diode 700 is laterally isolated from other devices formed on the substrate 101 by the deep trench isolation enclosure, via dielectric isolation. In this alternative embodiment, the through silicon via structure 162 has the only function to make the cathode electrode 160a of the Schottky diode 700 available to the wirings disposed on frontside surface 101a of the substrate 101; the through silicon via structure 162 does not provide a lateral isolation for the Schottky diode 700 in this alternative embodiment.

The manufacturing process of the Schottky diode 300 of Figure 3 is now discussed in more details (it is noted that the respective manufacturing process of the previously discussed alternative embodiments do not differ substantially from what will now be discussed, as will be evident for a skilled reader).

It is also noted that the manufacturing process is, in part, based on the process steps disclosed in the patent application EP 2 913 847 B1, in the name of the present Applicant (to which reference is made herein).

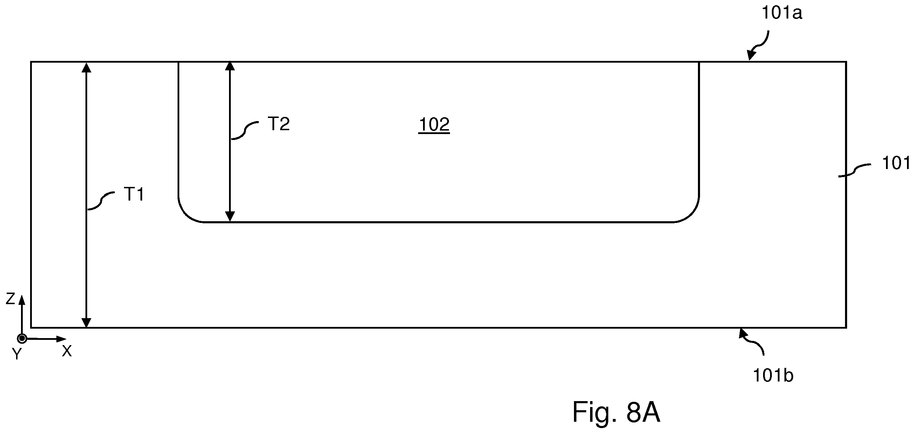

As shown in figure 8A, a first step of the manufacturing process envisages providing a wafer of semiconductor material having the substrate 101, with the frontside surface 101a and backside surface 101b. The thickness T1 of the substrate 101 may be e.g. several hundreds of microns. The substrate 101 is made of semiconductor material, e.g. silicon, having a second conductivity type, e.g. p-type; the substrate 101 may also be an epitaxial layer, grown on a silicon wafer; for example, substrate 101 may be a lightly-doped silicon epitaxial layer having p-type conductivity, grown on a highly-doped silicon wafer.

The lightly doped well 102 is then formed in the surface portion of the substrate 101, facing the frontside surface 101a thereof. The lightly doped well 102 is formed by masked implantation and subsequent annealing, and has the first conductivity type (n-type). However, a p-type doping (doping of the second conductivity type) of the well 102 may also be envisaged; doping of the lightly doped well 102 and of the substrate 101 may be of the opposite conductivity type or of the same conductivity type. Doping concentration of the lightly doped well 102 at the frontside surface 101a is for example between 1e¹⁵/cm³ to 1e¹⁷/cm³; more preferably, the doping concentration at the frontside surface 101a is between 5e¹⁵/cm³ to 5e¹⁶/cm³. The depth of the lightly doped well 102 is denoted by T2 and is lower than the depth of the substrate 101 in the same vertical direction z.

In general, in embodiments not covered by the appended claims, the Schottky contact could also be established on the same substrate 101, provided that the doping type and doping level is suitable. An n-type doping is preferred since a higher Richardson coefficient can be obtained. The light doping is generally required to obtain the desired Schottky characteristics.

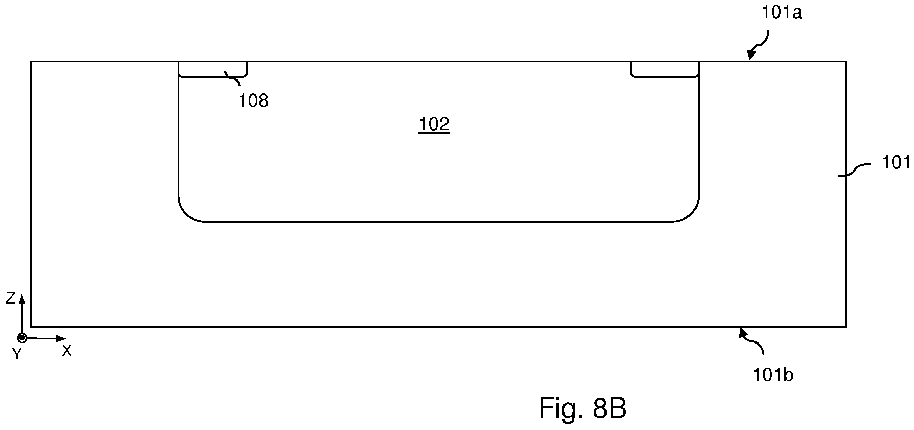

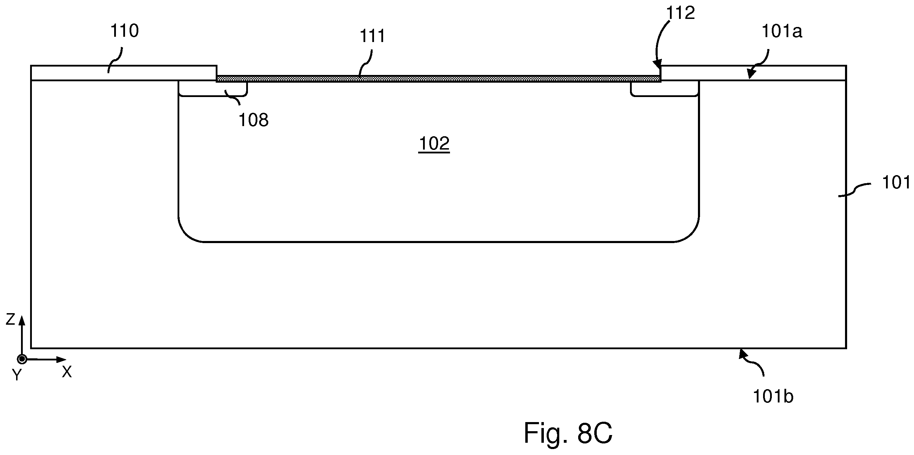

Subsequently, as shown in Figure 8B, the guard ring 108 is formed in the lightly doped well 102, at the frontside surface 101a. The guard ring 108 might be aligned to the peripheral edge of the lightly doped well 102 as shown in figure 8B. The guard ring 108 has the opposite conductivity type as the lightly doped well 102. In the preferred embodiment, in which the lightly doped well 102 has the first conductivity type, the guard ring 108 has the second conductivity type. The depth of the guard ring 108 is far smaller than the depth of the lightly doped well 102. The guard ring 108 could be formed together with source/drain implantations available in a standard CMOS process. Afterwards, as shown in Figure 8C, the silicide blocking layer 110 is deposited on the frontside surface 101a of the substrate 101. The silicide blocking layer 110 may be made of silicon oxide or a stack consisting of a silicon oxide layer and a silicon nitride layer disposed on the silicon oxide layer. The opening 112 is then formed through the silicide blocking layer 110 in the region where the Schottky contact will be formed. A cobalt silicide layer is formed in the opening 112 through the silicide blocking layer 110, to form the anode electrode 111 of the Schottky diode 300. The process of silicide formation is well known in the art and is therefore not described herein; in particular, a cobalt silicidation process sequence is available in many CMOS processes.

A Schottky diode could be formed also with other metals or metal silicides disposed on the lightly doped well 102, provided that the Schottky barrier height of the metal or metal silicide on the n-type or p-type well is suitable.

In the embodiment shown, the anode electrode 111 has an overlap on the guard ring 108, as shown in the same Figure 8C.

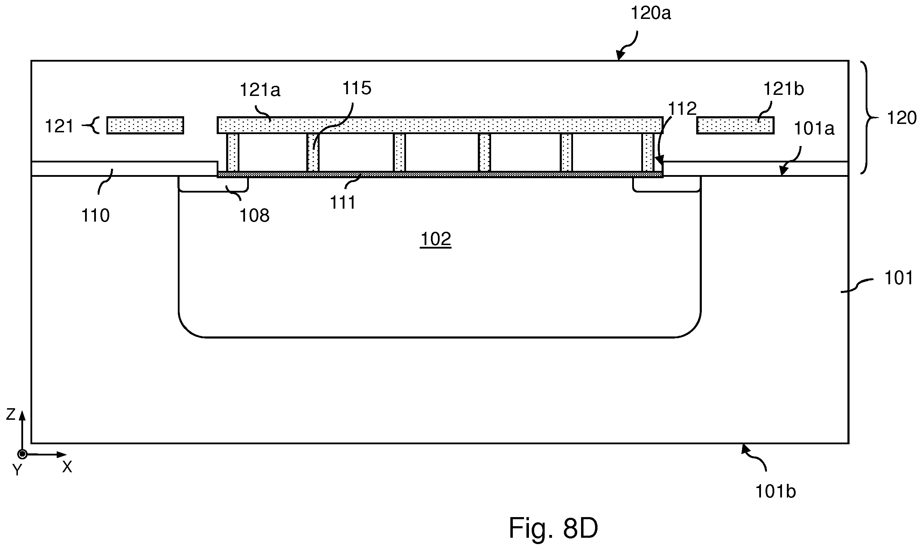

Turning now to Figure 8D, further processing steps are performed on the frontside surface 101a of the substrate 101, for the formation of the CMOS layer stack (including a suitable number of dielectric and interconnected conductive layers).

In particular, contacts 115 are formed in the intermetal dielectric layer 120, extending from the cobalt silicide layer of the anode electrode 111 and the first interconnection pad 121a formed in the first interconnection metal layer 121.

The second interconnection pad 121b is also formed in the same first interconnection metal layer 121, as a landing pad for the subsequently formed through silicon via structure 162 (as will be discussed in the following). Since, in the discussed embodiment, the through silicon via structure 162 encloses the Schottky diode 300, also the second interconnection pad 121b encloses laterally surrounds the first interconnection pad 121a, for example forming a ring around the same first interconnection pad 121a. The width of the second interconnection pad 121b is larger than the width of the subsequently formed through silicon via structure 162. Several interconnection metal layers and vias might be formed in the intermetal dielectric 120, as in standard CMOS processes.

In contrast to standard CMOS processes, no bonding pads are instead formed with the last interconnection metal layer, on the top surface 120a of the intermetal dielectric layer 120, after finishing of the frontside process steps. The top surface 120a is made of silicon oxide, and is essentially planar, which is achieved by chemical-mechanical polishing.

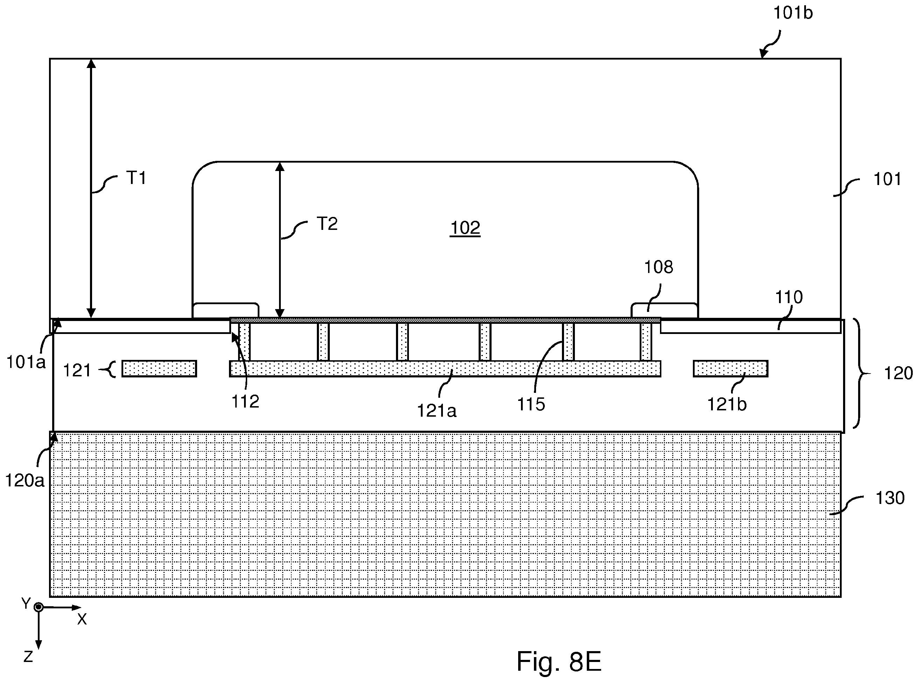

As shown in Figure 8E, the substrate 101 is then flipped (i.e. with the backside surface 101b facing up and the frontside surfaces 101a facing down), and the top surface 120a of the intermetal dielectric layer 120 is bonded onto a carrier wafer 130.

The carrier wafer 130 may be a semiconductor wafer or a wafer of different material that is compatible with CMOS manufacturing requirements. A permanent bond is achieved between the top surface 120a and the carrier wafer 130 (a possible method to achieve a permanent bond is described e.g. in EP 2 913 847 B1; however, any known method to achieve such a bonding may as well be used).

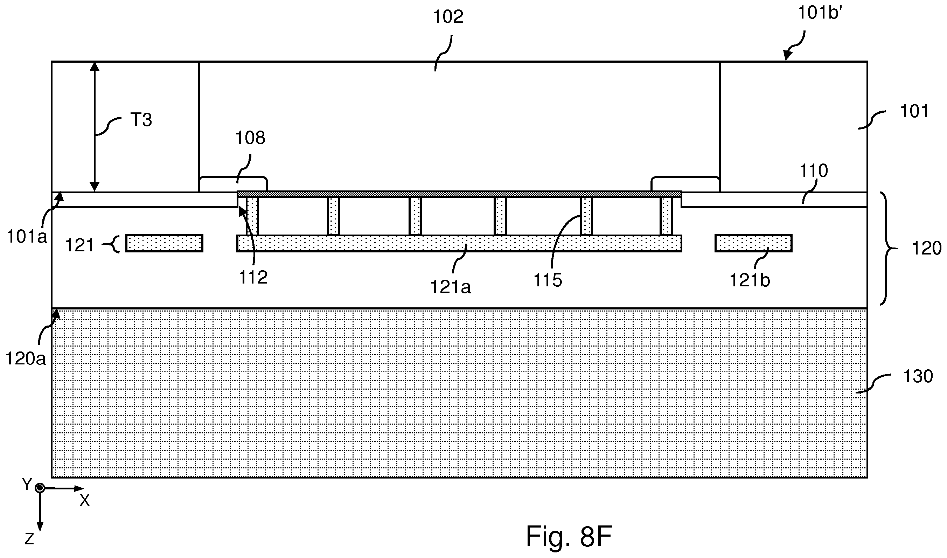

As shown in Figure 8F, the substrate 101 is then thinned from the backside surface 101b, by removing material from the backside. By the thinning step, the thickness of the substrate 101 is reduced from thickness T1 to a thickness T3. The thinning process can be performed by a combination of back-grinding, etching and chemical-mechanical polishing (again, a possible method for the thinning operation is described in EP 2 913 847 B1). A low and uniform thickness T3 can be achieved. The resulting thinned backside surface 101b' (that defines the actual backside surface of the resulting thinned substrate 101) is essentially planar. The thickness T3 is e.g. between 1.5µm and 15µm. The thickness T3 is required to be lower than the thickness T2 of the lightly doped well 102. In this way, the lightly doped well 102 becomes exposed at the thinned backside surface 101b' (if the Schottky diode 300 is formed in an epitaxial layer with suitable doping, this requirement does not apply).

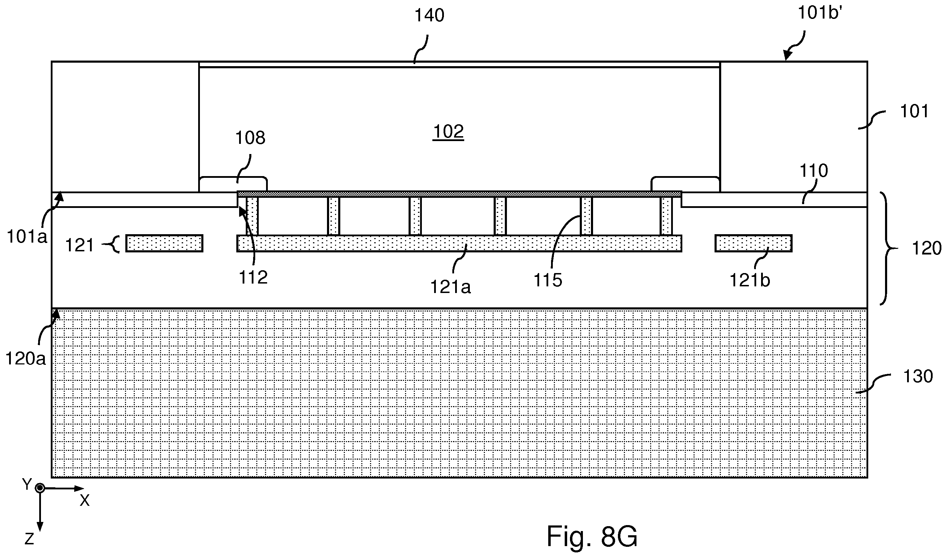

Turning now to Figure 8G, the shallow and highly doped region 140 is formed in the lightly doped well 102, at the thinned backside surface 101b'. The shallow and highly doped region 140 is formed e.g. by a resist-masked implantation followed by laser thermal annealing (processing details may again be found in EP 2 913 847 B1).

The highly doped region 140 may be aligned to the lightly doped well 102 as shown in the same Figure 8G. The doping level of the highly doped region 140 at the thinned backside surface 101b' is such that an Ohmic contact to the lightly doped well 102 can be achieved with a metal deposition.

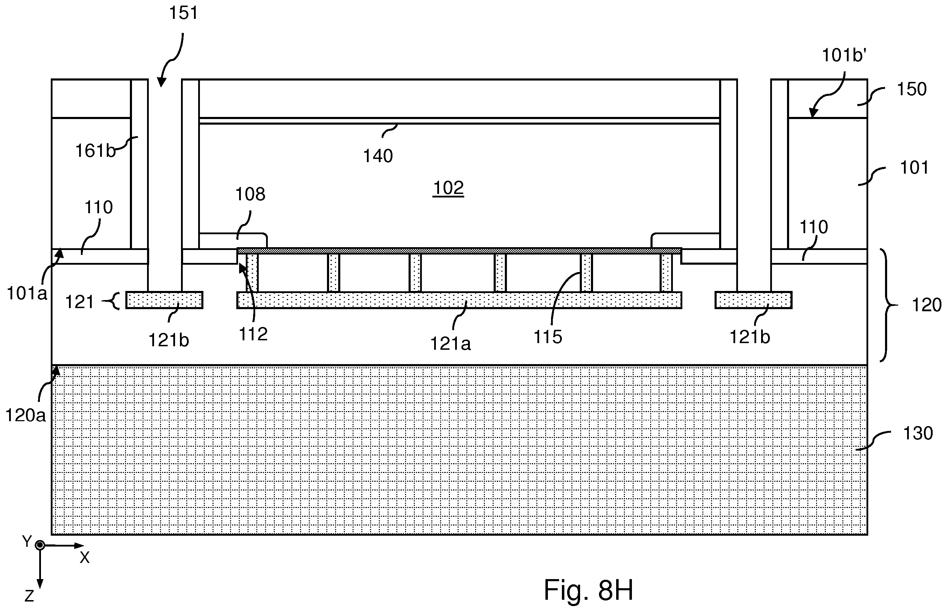

Afterwards, as shown in Figure 8H, the dielectric layer 150, made of silicon oxide or other dielectric material, is deposited on the thinned backside surface 101b' of the substrate 101. Then, a through silicon via (TSV) opening 151 is etched from the top of the dielectric layer 150 on the thinned backside surface 101b', extending to the silicide blocking layer 110. Dielectric liner 161b is then deposited into the etched TSV opening 151, and afterwards etching is continued such that the second interconnection pad 121b becomes exposed, at the bottom of the same TSV opening 151.

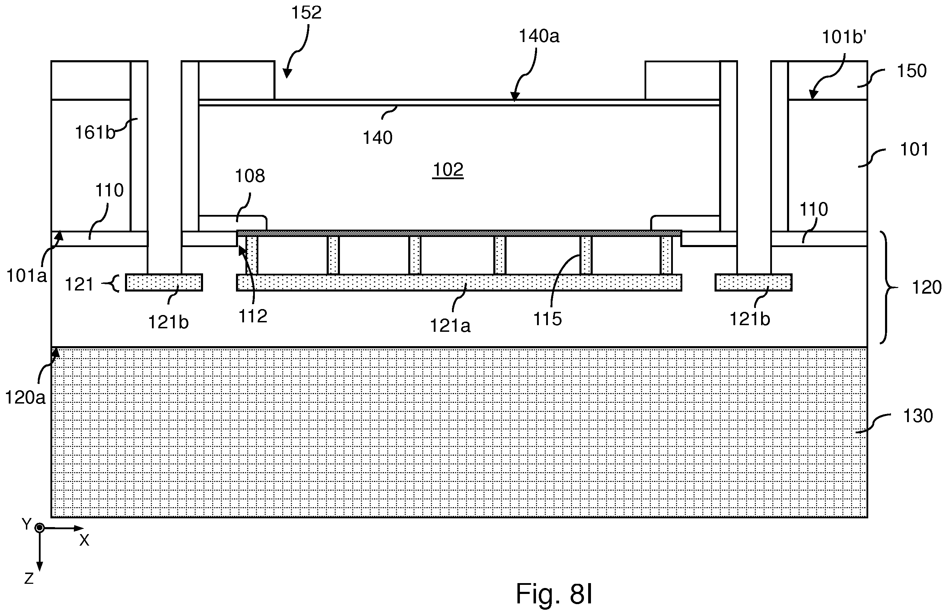

As shown in Figure 8I, the backside contact opening 152 is etched into dielectric layer 150, such that the highly doped region 140 becomes exposed. The backside contact opening 152 lies completely within the highly doped region 140. Over-etching is required to be very small so that at the resulting surface 140a the doping concentration is sufficiently high to allow the formation of an Ohmic metal contact at the same surface 140a.

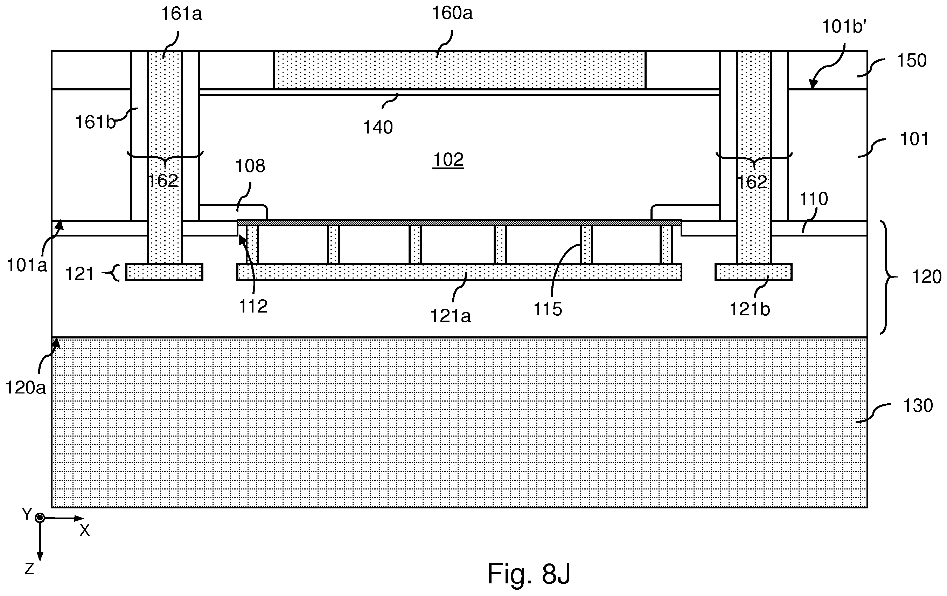

Turning now to Figure 8J, the through silicon via opening 151, as well as the backside contact opening 152, are filled with conductive material, e.g. aluminum, tungsten or copper (the conductive materials can include adhesion and barrier layers, in a per-se known manner), to form both the conductive filling 161a of the through silicon via structure 162 (which is thereby formed) and, concurrently, the cathode electrode 160a of the Schottky diode 300. Preferably, metal formation is followed by chemical-mechanical polishing. As already discussed, by depositing a metal into the backside contact opening 152, an Ohmic metal contact is formed on the lightly doped well 102, from the backside.

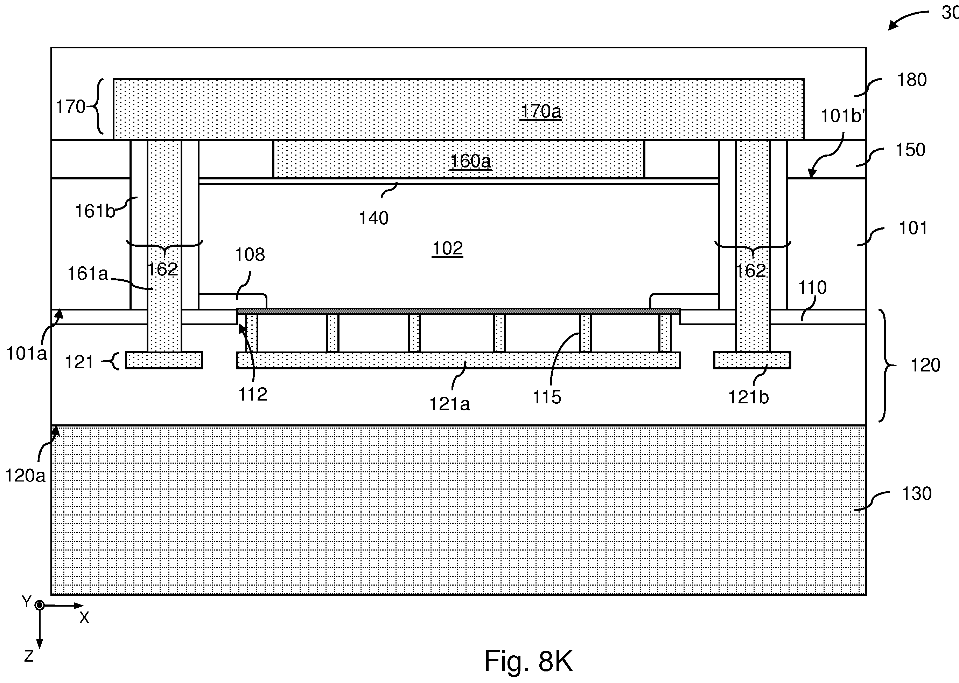

As shown in Figure 8K, the first interconnection layer 170, e.g. made of aluminum or copper, is formed on the backside surface 101b', in particular on the dielectric layer 150. The first interconnection layer 170 is then patterned to form the first interconnection region 170a, which establishes an electrical connection between the through silicon via structure 162 and the cathode electrode 160a. More interconnection metal layers and vias could be added on the same backside surface 101b' to form suitable connection patterns on the same backside surface 101b'. The first interconnection layer 170 are disposed in an intermetal dielectric 180. The intermetal dielectric 180 may be silicon oxide or a spin-on dielectric like polyimide, benzocyclobutene, or the like.

Bonding or bumping pads (here not shown) are subsequently formed with the last backside metal interconnection layer, suitably connected to the anode and/or cathode electrodes 111, 160a of the Schottky diode 300 (and/or to the further integrated circuit formed in the substrate 101), to make the electric signals available to the outside (the formation of these pads 190 is per-se known, and is not discussed in detail herein).

The advantages that the proposed solution allows to achieve are clear from the foregoing disclosure.

In particular, by forming anode and cathode electrodes 111, 160a of the Schottky diode on opposite sides of a same thinned substrate 101, a high area efficiency can be achieved. The added series resistance due to the backside metal wiring and the required through silicon via is low compared to the parasitic series resistance introduced, e.g., by a buried layer and a sinker. In the proposed Schottky diode there is no fundamental limit for the size of the same anode and cathode electrodes 111, 160a. The area consumption of the through silicon via structure 162 is typically lower than the area consumption of a sinker structure.

Besides the advantage of having a lower area consumption and a reduced series resistance, the proposed high voltage Schottky diode has the following additional advantages:
- no parasitic bipolar transistor (the electrical characteristics of the Schottky diode cannot be impaired by the action of a parasitic bipolar transistor);
- very low substrate current (due to a full dielectric isolation);
- reduced edge leakage in reverse bias (due to the fact the equipotential distribution in reverse bias is nearly planar; this helps to reduce the electric field at the edge of the Schottky area).

Moreover, minority carrier injection and parasitic capacitance can be minimized by a proper layout of the proposed Schottky diode. The guard ring 108 introduces a parasitic capacitance into the device and can give rise to minority carrier injection. Minority carrier injection increases the reverse recovery time of the diode in switching applications. The layout of the proposed Schottky diode can be chosen to have a high area-to-perimeter ratio. For instance, the layout can be chosen to be circular or quadratic or nearly quadratic. In this way the total guard ring area for a given Schottky area can be minimized. The proposed Schottky diode has thus a reduced switching loss.

The manufacturing process envisages standard steps of CMOS processing, thus having reduced complexity and costs. The higher area efficiency and reduced series resistance of the proposed integrated Schottky diode translates into a further cost advantage.

Finally, it is clear that modifications and variations may be made to what has been described and illustrated herein, without thereby departing from the scope of the present invention, as defined in the annexed claims.

## Claims

1. A semiconductor device (300; 400; 500; 600; 700) comprising an integrated vertical Schottky diode, said device comprising:
• a substrate (101) of semiconductor material, having a front surface (101a) and a back surface (101b') and an integrated circuit formed therein;
• a lightly doped region (102) formed in a surface portion of the substrate (101) facing the front surface (101a), having a first conductivity type;
• a first electrode (111) formed on the lightly doped region (102) on the front surface (101a) of the substrate (101), to establish a Schottky contact;
• a highly doped region (140) at the back surface (101b') of the substrate (101), in contact with the lightly doped region (102) and having the first conductivity type;
• a second electrode (160a) electrically in contact with the highly doped region (140), on the back surface (101b') of the substrate (101), to establish an Ohmic contact;
• further comprising an intermetal dielectric layer (120) on the front surface (101a) of the substrate (101) and at least a first frontside interconnection metal layer (121) arranged in the intermetal dielectric layer (120) above said front surface (101a);
• a first interconnection pad (121a) defined in said first frontside interconnection metal layer (121) and providing a first electrical contact available at the front surface (101a), electrically contacting said first electrode (111) via contacts (115) extending through said intermetal dielectric layer (120);
• a further intermetal dielectric layer (180) above the back surface (101b') of the substrate (101) and at least a first backside interconnection metal layer defining at least a first interconnection region (170a, 170b) arranged in the further intermetal dielectric layer (180);
• further comprising a through silicon via structure (162), including a dielectric liner (161b) and a conductive filling (161a), and laterally enclosing said lightly doped region (102) and said highly doped region (140), providing an electrical isolation, wherein:
∘ said device comprises a second interconnection pad (121b) defined in said first frontside interconnection metal layer (121) to provide a second electrical contact available at said front surface (101a) and said through silicon via structure (162) extends from said second interconnection pad (121b) to said at least first interconnection region (170a) which is in electrical contact with the second electrode (160a), the conductive filling (161a) of the through silicon via structure (162) establishing an electrical contact between the second electrode (160a) and the second interconnection pad (121b);
∘ **or** said through silicon via structure (162) extends from the first interconnection pad (121a) to a second interconnection region (170b) defined in said first backside interconnection metal layer, the conductive filling (161a) of the through silicon via structure (162) establishing an electrical contact between the first electrode (111) and the second interconnection region (170b), which thereby provides a first electrical contact available at said back surface (101b'), the first interconnection region (170a) being in electrical contact with the second electrode (160a) and providing a second electrical contact available at said back surface (101b').

2. The device according to claim 1, further comprising a carrier wafer (130) bonded to a top surface (120a) of said intermetal dielectric layer (120).

3. The device according to claim 1 or 2, wherein said first electrode (111) is formed of a metal silicide layer.

4. The device according to any of the preceding claims, further comprising a guard ring (108), constituted by a doped region of a second conductivity type, opposite to the first conductivity type, arranged in a perimeter region of the lightly doped region (102) at the front surface (101a) of the substrate (101).

5. The device according to claim 4, wherein the guard ring (108) overlaps and is in contact with the first electrode (111); or does not contact the first electrode (111) and is floating.

6. The device according to any of the preceding claims, further comprising a grid (188) of doped regions (109) of a second conductivity type, opposite to the first conductivity type, arranged in the lightly doped region (102) at the front surface (101a) of the substrate (101), having identical width and being equidistant.

7. The device according to any of the preceding claims, further comprising a deep-trench isolation region (106) of a dielectric material, extending from the back surface (101b') of the substrate (101) to a shallow-trench isolation (104) formed in the lightly doped region (102) at the frontside surface (101a) of the substrate (101); said shallow-trench isolation (104) and deep-trench isolation region (106) jointly laterally enclosing said lightly doped region (102) and said highly doped region (140) providing a dielectric isolation.

8. A method for manufacturing a semiconductor device (300; 400; 500; 600; 700) comprising an integrated vertical Schottky diode, said method comprising:
• providing a substrate (101) of semiconductor material, having a front surface (101a) facing upwards and a back surface (101b') opposite to the front surface (101a) and an integrated circuit formed therein; and
• forming a lightly doped region (102) in a surface portion of the substrate (101) facing the front surface (101a), having a first conductivity type;
• forming a first electrode (111) on the lightly doped region (102) on the front surface (101a) of the substrate (101), to establish a Schottky contact;
• forming an intermetal dielectric layer (120) on the front surface (101a) of the substrate (101) and at least a first frontside interconnection metal layer (121) arranged in the intermetal dielectric layer (120) above said front surface (101a);
• defining a first interconnection pad (121a) in said first frontside interconnection metal layer (121), electrically contacting said first electrode (111) via contacts (115) extending through said intermetal dielectric layer (120);
• flipping the substrate (101), so that a backside (101b) thereof, opposite to the front surface (101a), faces upwards;
• thinning the substrate (101) from the back surface (101b);
• forming a highly doped region (140) at the thinned back surface (101b') of the substrate (101), in contact with the lightly doped region (102) and having the first conductivity type;
• forming a second electrode (160a) electrically in contact with the highly doped region (140), on the thinned back surface (101b') of the substrate (101), to establish an Ohmic contact;
• forming a further intermetal dielectric layer (180) above the back surface (101b') of the substrate (101) and at least a first backside interconnection metal layer defining at least a first interconnection region (170a) and a second interconnection region (170b) arranged in the further intermetal dielectric layer (180);
• forming a through silicon via structure (162), including a dielectric liner (161b) and a conductive filling (161a), to laterally enclose said lightly doped region (102) and said highly doped region (140), providing an electrical isolation, wherein said method further comprises:
∘ defining a second interconnection pad (121b) in said first frontside interconnection metal layer (121) to provide a second electrical contact available at said front surface (101a), and forming said through silicon via structure (162) to extend from said second interconnection pad (121b) to said at least first interconnection region (170a), which is formed in electrical contact with the second electrode (160a), thereby establishing an electrical contact between the second electrode (160a) and the second interconnection pad (121b);
∘ **or** forming said through silicon via structure (162) to extend from the first interconnection pad (121a) to said second interconnection region (170b), thereby establishing an electrical contact between the first electrode (111) and the second interconnection region (170b) to provide a first electrical contact available at said back surface (101b'), wherein the first interconnection region (170a) is formed in electrical contact with the second electrode (160a) to provide a second electrical contact available at said back surface (101b').

9. The method according to claim 8, wherein the step of thinning the substrate (101) from the back surface (101b') further comprises:
• bonding a carrier wafer (130) to the frontside surface (101a) of the substrate (101);
• processing the substrate (101) at the backside (101b) thereof,
• executing a thinning step such as to expose the lightly doped region (102) and define said back surface (101b').

10. The method according to claim 98 or 9, wherein forming the second electrode (160a) includes:
• forming a dielectric layer (150) on the back surface (101b');
• etching a contact opening (152) through the dielectric layer (150), at the area of the highly doped region (140);
• filling the contact opening (152) with a conductive region, constituting said second electrode (160a).

## Patentansprüche

1. Halbleitervorrichtung (300; 400; 500; 600; 700) mit einer integrierten vertikalen Schottky-Diode, wobei die Vorrichtung Folgendes umfasst:
* ein Substrat (101) aus Halbleitermaterial, das eine Vorderseite (101a), eine Rückseite (101b') und eine darin ausgebildete integrierte Schaltung aufweist;
* einen schwach dotierten Bereich (102), der in einem zur Vorderseite (101a) hin orientierten Oberflächenbereich des Substrats (101) ausgebildet ist und einen ersten Leitfähigkeitstyp aufweist;
* eine erste Elektrode (111), die auf dem schwach dotierten Bereich (102) an der Vorderseite (101a) des Substrats (101) ausgebildet ist, um einen Schottky-Kontakt herzustellen;
* einen stark dotierten Bereich (140) an der Rückseite (101b') des Substrats (101), der mit dem schwach dotierten Bereich (102) in Kontakt steht und den ersten Leitfähigkeitstyp aufweist;
* eine zweite Elektrode (160a), die an der Rückseite (101b') des Substrats (101) in elektrischem Kontakt mit dem stark dotierten Bereich (140) steht, um einen Ohmschen Kontakt herzustellen;
* ferner umfassend eine Zwischenmetall-Dielektrikum-Schicht (120) auf der Vorderseite (101a) des Substrats (101) und mindestens eine erste Metall-Verbindungsschicht (121) auf der Vorderseite, die in der Zwischenmetall-Dielektrikums-Schicht (120) über der Vorderseite (101a) angeordnet ist;
* eine erste Verbindungsplatte (121a), die in der ersten, vorderseitigen Metallverbindungsschicht (121) definiert ist und einen ersten, an der Vorderseite (101a) verfügbaren elektrischen Kontakt bereitstellt, wobei sie über Kontakte (115), die sich durch die dielektrische Zwischenmetallschicht (120) erstrecken, in elektrischem Kontakt mit der ersten Elektrode (111) steht;
* eine weitere dielektrische Zwischenmetallschicht (180) über der Rückseite (101b') des Substrats (101) sowie mindestens eine rückseitige Metallverbindungsschicht, die mindestens einen ersten Verbindungsbereich (170a, 170b) definiert, welcher in der weiteren dielektrischen Zwischenmetallschicht (180) angeordnet ist;
* ferner umfassend eine Silizium-Durch-Kontaktierungsstruktur (162), die eine dielektrische Auskleidung (161b) und eine leitfähige Füllung (161a) aufweist und die schwach dotierte Region (102) sowie die stark dotierte Region (140) seitlich umschließt, um eine elektrische Isolierung zu gewährleisten, wobei:
° die Vorrichtung eine zweite Verbindungsplatte (121b) umfasst, die in der ersten vorderseitigen Metallverbindungsschicht (121) definiert ist, um einen zweiten elektrischen Kontakt bereitzustellen, der an der Vorderseite (101a) verfügbar ist, sowie die Durch-Kontaktierungsstruktur (162), die sich von der zweiten Verbindungsfläche (121b) bis zu der mindestens einen ersten Verbindungsregion (170a) erstreckt, welche in elektrischem Kontakt mit der zweiten Elektrode (160a) steht, wobei die leitfähige Füllung (161a) der Durch-Kontaktierungsstruktur (162) einen elektrischen Kontakt zwischen der zweiten Elektrode (160a) und der zweiten Verbindungsfläche (121b) herstellt;
° oder die Silizium-Durch-Kontaktierungsstruktur (162) erstreckt sich von der ersten Verbindungsebene (121a) bis zu einem zweiten Verbindungsbereich (170b), der in der besagten ersten rückseitigen Metallverbindungsschicht definiert ist, wobei die leitfähige Füllung (161a) der Silizium-Durch-Kontaktierungsstruktur (162) einen elektrischen Kontakt zwischen der ersten Elektrode (111) und dem zweiten Verbindungsbereich (170b) herstellt, welcher in diesem Fall einen ersten, an der besagten Rückseite (101b') verfügbaren elektrischen Kontakt bereitstellt, wobei der erste Verbindungsbereich (170a) in elektrischem Kontakt mit der zweiten Elektrode (160a) steht und einen zweiten, an der Rückseite (101b') verfügbaren elektrischen Kontakt bereitstellt.

2. Vorrichtung nach Anspruch 1, ferner umfassend einen Trägerwafer (130), der mit einer oberen Fläche (120a) der dielektrischen Zwischenmetallschicht (120) verbunden ist.

3. Vorrichtung nach Anspruch 1 oder 2, bei der die erste Elektrode (111) aus einer Metallsilizid-Schicht gebildet ist.

4. Vorrichtung nach einem der vorhergehenden Ansprüche, ferner umfassend einen Schutzring (108), der aus einem dotierten Bereich eines zweiten Leitfähigkeitstyps - entgegengesetzt zum ersten Leitfähigkeitstyp - besteht und in einem Randbereich des schwach dotierten Bereichs (102) an der Vorderseite (101a) des Substrats (101) angeordnet ist.

5. Vorrichtung nach Anspruch 4, bei der der Schutzring (108) die erste Elektrode (111) überlappt und mit ihr in Kontakt steht oder nicht mit der ersten Elektrode (111) in Kontakt steht und potentialfrei schwebend ist.

6. Vorrichtung nach einem der vorhergehenden Ansprüche, ferner umfassend ein Gitter (188) aus dotierten Bereichen (109) eines zweiten Leitfähigkeitstyps - entgegengesetzt zum ersten Leitfähigkeitstyp -, die in dem schwach dotierten Bereich (102) an der Vorderseite (101a) des Substrats (101) angeordnet sind, eine identische Breite aufweisen und äquidistant sind.

7. Vorrichtung nach einem der vorhergehenden Ansprüche, ferner umfassend einen Tiefgraben-Isolationsbereich (106) aus einem dielektrischen Material, der sich von der Rückseite (101b') des Substrats (101) bis zu einer Flachgraben-Isolation (104) erstreckt, welche in dem schwach dotierten Bereich (102) an der Vorderseite (101a) des Substrats (101) ausgebildet ist; wobei die Flachgraben-Isolation (104) und der Tiefgraben-Isolationsbereich (106) gemeinsam den schwach dotierten Bereich (102) und den stark dotierten Bereich (140) seitlich umschließen und eine dielektrische Isolation bewirken.

8. Verfahren zur Herstellung einer Halbleitervorrichtung (300; 400; 500; 600; 700), die eine integrierte vertikale Schottky-Diode umfasst, wobei das Verfahren Folgendes umfasst:
* Bereitstellen eines Substrats (101) aus Halbleitermaterial, mit einer nach oben weisenden Vorderseite (101a) und einer der Vorderseite (101a) gegenüberliegenden Rückseite (101b') und einer darin ausgebildeten integrierten Schaltung ; und
* Ausbilden eines schwach dotierten Bereichs (102) in einem zur Vorderseite (101a) weisenden Oberflächenabschnitt des Substrats (101), der einen ersten Leitfähigkeitstyp aufweist;
* Ausbilden einer ersten Elektrode (111) auf dem schwach dotierten Bereich (102) an der Vorderseite (101a) des Substrats (101) zur Herstellung eines Schottky-Kontakts;
* Ausbilden einer Zwischenmetall-Dielektrikumsschicht (120) auf der Vorderseite (101a) des Substrats (101) und mindestens einer ersten vorderseitigen Verbindungsmetallschicht (121), die in der Zwischenmetall-Dielektrikum-Schicht (120) oberhalb der Vorderseite (101a) angeordnet ist;
* Definieren einer ersten Verbindungskontaktplatte (121a) in der ersten vorderseitigen Verbindungsmetallschicht (121), die die erste Elektrode (111) über Kontakte (115) elektrisch kontaktiert, welche sich durch die Zwischenmetall-Dielektrikum-Schicht (120) erstrecken;
* Wenden des Substrats (101), sodass dessen Rückseite (101b), die der Vorderseite (101a) gegenüberliegt, nach oben weist;
* Dünner-Machen des Substrats (101) von der Rückseite (101b) her;
* Ausbilden eines stark dotierten Bereichs (140) an der verdünnten Rückseite (101b') des Substrats (101), der in Kontakt mit dem schwach dotierten Bereich (102) steht und den ersten Leitfähigkeitstyp aufweist;
* Ausbilden einer zweiten Elektrode (160a), die in elektrischem Kontakt auf der verdünnten Rückseite (101b') des Substrats (101 mit dem stark dotierten Bereich (140) steht, um einen ohmschen Kontakt herzustellen;
* Ausbilden einer weiteren dielektrischen intermetallischen Schicht (180) an der Rückseite (101b') des Substrats (101) und mindestens einer ersten metallischen Rückseiteninterconnection-Schicht, die mindestens einen ersten Interconnections-Bereich (170a) und einen zweiten Interconnections-Bereich (170b) definieren, die in der weiteren dielektrischen Intermetall-Schicht (180) angeordnet sind;
Ausbilden einer Silizium-Durchkontaktierungs Struktur (162), die eine dielektrische Auskleidung (161b) und eine leitfähige Füllung (161a) umfasst, um den schwach dotierten Bereich (102) und den stark dotierten Bereich (140) seitlich zu umschließen und eine elektrische Isolierung zu gewährleisten, wobei das Verfahren ferner Folgendes umfasst:
° Definieren einer zweiten Interconnections-Platte (121b) in der vorderseitigen Verbindungsmetallschicht (121), um einen zweiten elektrischen Kontakt bereitzustellen, der an der Vorderseite (101a) verfügbar ist, und Ausbilden der Silizium-Durchkontaktierungs-Struktur (162), die sich von der zweiten Verbindungsplatte (121b) bis zu dem mindestens einen ersten Verbindungsbereich (170a) erstreckt, welcher in elektrischem Kontakt mit der zweiten Elektrode (160a) ausgebildet ist, wodurch ein elektrischer Kontakt zwischen der zweiten Elektrode (160a) und der zweiten Verbindungsplatte (121b) hergestellt wird;
° oder Ausbilden der Silizium-Durchkontaktierungs-Struktur (162), die sich von der ersten Verbindungsplatte (121a) bis zu dem zweiten Verbindungsbereich (170b) erstreckt, wodurch ein elektrischer Kontakt zwischen der ersten Elektrode (11) und dem zweiten Verbindungsbereich (170b) hergestellt wird, um einen ersten elektrischen Kontakt bereitzustellen, der an der Rückseite (101b') verfügbar ist, wobei der erste Verbindungsbereich (170a) in elektrischem Kontakt mit der zweiten Elektrode (160a) ausgebildet ist, um einen zweiten elektrischen Kontakt bereitzustellen, der an der Rückseite (101b') verfügbar ist.

9. Verfahren nach Anspruch 8, wobei der Schritt des Ausdünnens des Substrats (101) von der Rückseite (101b) aus ferner Folgendes umfasst:
* Verbinden eines Trägerwafers (130) mit der vorderseitigen Fläche (101a) des Substrats (101);
* Bearbeiten des Substrats (101) an dessen Rückseite (101b)
* Durchführen eines Dünnungsschritts, um den schwach dotierten Bereich (102) freizulegen und die Rückseite (101b') zu definieren.

10. Verfahren nach Anspruch 8 oder 9, wobei das Ausbilden der zweiten Elektrode (160a) Folgendes umfasst:
* Ausbilden einer dielektrischen Schicht (150) auf der Rückseite (101b');
* Ätzen einer Kontaktöffnung (152) durch die dielektrische Schicht (150) beim Bereich des hochdotierten Bereichs (140);
* Füllen der Kontaktöffnung (152) mit einem leitfähigen Bereich, der die besagte zweite Elektrode (160a) bildet.

## Revendications

1. Dispositif à semi-conducteur (300; 400; 500; 600; 700) comprenant une diode Schottky verticale intégrée, ledit dispositif comprenant :
* un substrat (101) en matériau semi-conducteur, présentant une face avant (101a) et une face arrière (101b') et un circuit intégré formé à son intérieur ;
* une région faiblement dopée (102) formée dans une partie superficielle du substrat (101) orienté vers la face avant (101a), présentant un premier type de conductivité ;
* une première électrode (111) formée sur la région faiblement dopée (102) sur la face avant (101a) du substrat (101), pour établir un contact Schottky ;
* une région fortement dopée (140) au niveau de la face arrière (101b') du substrat (101), en contact avec la région faiblement dopée (102) et présentant le premier type de conductivité ;
* une deuxième électrode (160a) en contact électrique avec la région fortement dopée (140), sur la face arrière (101b') du substrat (101), pour établir un contact ohmique ;
* comprenant en outre une couche diélectrique intermétallique (120) sur la face avant (101a) du substrat (101) et au moins une première couche métallique d'interconnexion côté face avant (121) disposée dans la couche diélectrique intermétallique (120) au-dessus de ladite face avant (101a) ;
* une première plaquette d'interconnexion (121a) définie dans ladite première couche métallique d'interconnexion côté face avant (121), et formant un premier contact électrique disponible sur la face avant (101a), en contact électrique avec ladite première électrode (111) au moyen de contacts (115) s'étendant à travers ladite couche diélectrique intermétallique (120);
* une couche diélectrique intermétallique ultérieure (180) au-dessus de la face arrière (101b') du substrat (101), et au moins une première couche métallique d'interconnexion côté face arrière, définissant au moins une première région d'interconnexion (170a, 170b) disposée dans la couche diélectrique intermétallique ultérieure (180) ;
* comprenant en outre une structure de via traversant le silicium (162), comprenant une doublure diélectrique (161b) et un remplissage conducteur (161a), et enveloppant latéralement ladite région faiblement dopée (102) et ladite région fortement dopée (140), formant une isolation électrique, dans lequel :
° ledit dispositif comprend une deuxième plaquette d'interconnexion (121b) définie dans ladite première couche métallique d'interconnexion côté face avant (121) pour former un deuxième contact électrique disponible sur la face avant (101a) et sur ladite structure de via traversant le silicium (162) s'étendant de ladite deuxième plaquette d'interconnexion (121b) jusqu'à ladite au moins première région d'interconnexion (170a), qui se trouve en contact électrique avec la deuxième électrode (160a), le remplissage conducteur (161a) de la structure de via traversant le silicium (162) établissant un contact électrique entre la deuxième électrode (160a) et la deuxième plaquette d'interconnexion (121b) ;
° ou ladite structure de via traversant le silicium (162) s'étend de la première plaquette d'interconnexion (121a) jusqu'à une deuxième région d'interconnexion (170b) définie dans ladite première couche métallique d'interconnexion côté face arrière, le remplissage conducteur (161a) de la structure de via traversant le silicium (162) établissant un contact électrique entre la première électrode (111) et la deuxième région d'interconnexion (170b), qui en ce cas forme un premier contact électrique disponible sur ladite face arrière (101b'), la première région d'interconnexion (170a) se trouvant en contact électrique avec la deuxième électrode (160a) et formant un deuxième contact électrique disponible sur ladite face arrière (101b').

2. Dispositif selon la revendication 1, comprenant en outre une plaquette porteuse (130) liée à une face supérieure (120a) de ladite couche diélectrique intermétallique (120).

3. Dispositif selon la revendication 1 ou 2, dans lequel ladite première électrode (111) est formée d'une couche de siliciure métallique.

4. Dispositif selon l'une quelconque des revendications précédentes, comprenant en outre un anneau de garde (108), constitué par une région dopée d'un deuxième type de conductivité, opposée au premier type de conductivité, disposée dans une région périphérique de la région faiblement dopée (102) au niveau de la face avant (101a) du substrat (101).

5. Dispositif selon la revendication 4, dans lequel l'anneau de garde (108) chevauche et est en contact avec la première électrode (111), ou n'est pas en contact avec la première électrode (111) et est flottant.

6. Dispositif selon l'une quelconque des revendications précédentes, comprenant en outre une grille (188) de régions dopées (109) d'un deuxième type de conductivité, opposé au premier type de conductivité, disposées dans la région faiblement dopée (102) au niveau de la face avant (101a) du substrat (101), présentant une largeur identique et étant équidistante.

7. Dispositif selon l'une quelconque des revendications précédentes, comprenant en outre une région d'isolation par tranchée profonde (106) d'un matériau diélectrique, s'étendant à partir de la face arrière (101b') du substrat (101) jusqu'à une isolation par tranchée peu profonde (104) formée dans la région légèrement dopée (102) au niveau de la face côté avant (101a) du substrat (101) ; ladite isolation par tranchée peu profonde (104) et ladite région d'isolation par tranchée profonde (106) enveloppant ensemble latéralement ladite région faiblement dopée (103) et ladite région fortement dopée (140) formant une isolation diélectrique.

8. Procédé de fabrication d'un dispositif à semi-conducteur (300; 400; 500; 600; 700) comprenant une diode Schottky verticale intégrée, ledit procédé comprenant :
* fournir un substrat (101) en matériau semi-conducteur présentant une face avant (101a) orientée vers le haut et une face arrière (101b) opposée à la face avant (101a) ; et
* former une région faiblement dopée (102) dans une partie de surface du substrat (101) orientée vers la face avant (101a), présentant un premier type de conductivité;
* former une première électrode (111) sur la région faiblement dopée (102), sur la face avant (101a) du substrat (101), pour établir un contact Schottky ;
* former une couche diélectrique intermétallique (120) sur la face avant (101a) du substrat (101) et au moins une première couche métallique d'interconnexion côté face avant (121) disposée dans la couche diélectrique intermétallique (120) au-dessus de ladite face avant (101a) ;
* définir une première plaquette d'interconnexion (121a) dans ladite première couche métallique d'interconnexion côté face avant (121), établissant un contact électrique avec ladite première électrode (111) par des contacts (121) s'étendant à travers la couche diélectrique intermétallique (120);
* retourner le substrat (101) de manière à ce que sa face arrière (101b), opposée à la face avant (101a), soit orientée vers le haut ;
* amincir le substrat (101) depuis la face arrière (101b);
* former une région fortement dopée (140) sur la face arrière amincie (101b') du substrat (101), en contact avec la région faiblement dopée (102) et présentant le premier type de conductivité ;
* former une deuxième électrode (160a), en contact électrique avec la région fortement dopée (140), sur la face arrière amincie (101b') du substrat (101), afin d'établir un contact ohmique;
* former une couche diélectrique intermétallique ultérieure (180) au-dessus de la face arrière (101b') du substrat (101) et au moins une première couche métallique d'interconnexion côté face arrière, définissant au moins une première région d'interconnexion (170a) et une deuxième région d'interconnexion (170b) disposées dans la couche diélectrique intermétallique ultérieure (180) ;
* former une structure de via traversant le silicium (162), comprenant une doublure diélectrique (161b) et un remplissage conducteur (161a), pour envelopper latéralement ladite région faiblement dopée (102) et ladite région fortement dopée (140), formant une isolation électrique, dans lequel ledit procédé comprend en outre:
° définir une deuxième plaquette d'interconnexion (121b) dans ladite première couche métallique d'interconnexion côté face avant (121) pour former un deuxième contact électrique disponible à niveau de ladite face avant (101a), et former ladite structure de via traversant le silicium (162) s'étendant à partir de ladite deuxième plaquette d'interconnexion (121b) jusqu'à ladite au moins première région d'interconnexion (170a), qui est formée en contact électrique avec la deuxième électrode (160a), établissant ainsi un contact électrique entre la deuxième électrode (160a) et la deuxième plaquette d'interconnexion (121b);
° ou former ladite structure de via traversant le silicium (162) s'étendant à partir de la première plaquette d'interconnexion (121a) jusqu'à ladite deuxième région d'interconnexion (170b), établissant ainsi un contact électrique entre la première électrode (111) et la deuxième région d'interconnexion (170b) pour former un premier contact électrique disponible au niveau de ladite face arrière (101b'1, dans lequel la première région d'interconnexion (170a) est formée en contact électrique avec la deuxième électrode (160a) pour former un deuxième contact électrique disponible au niveau de ladite face arrière (101b').

9. Procédé selon la revendication 8, dans lequel l'étape d'amincissement du substrat (101) depuis la face arrière (101b) comprend en outre :
* collage d'une plaquette porteuse (130) sur la face côté avant (101a) du substrat (101);
* traitement du substrat (101) au niveau du côté arrière (101b) de celui-ci,
* réalisation d'une étape d'amincissement, afin d'exposer la région faiblement dopée (102) et de définir ladite face arrière (101b') de celle-ci.

10. Procédé selon la revendication 8 ou 9, dans lequel la formation de la deuxième électrode (160a) comprend :
* formation d'une couche diélectrique (150) sur la face arrière (101b') ;
* gravure d'une ouverture de contact (152) à travers la couche diélectrique (150) au niveau de la région fortement dopée (140) ;
* remplissage de l'ouverture de contact (152) avec une région conductrice formant ladite deuxième électrode (160a).
